# EUROPEAN PATENT APPLICATION

(11) **EP 4 715 821 A1**
(43) Date of publication of application: **25.03.2026**
(21) Application number: 24916527.5
(22) Date of filing: 25.10.2024
(51) Int. Cl.: G11C 11/4091

(54) **SEMICONDUCTOR MEMORY**

(30) Priority: 10.01.2024 CN 202410034319
(71) Applicant: CXMT Corporation, Hefei City, Anhui Province 230601 (CN)
(72) Inventor: SHANG, Weibing, Hefei, Anhui 230601 (CN); GAO, Yicheng, Hefei, Anhui 230601 (CN)
(74) Representative: Gulde & Partner
(86) International application number: PCT/CN2024/127273
(87) International publication number: WO 2025/148476

(57) **Abstract**

The present disclosure provides a semiconductor memory, including: a first amplification module, configured to amplify a voltage difference between a bit line and a complementary bit line; and a second amplification module, configured to amplify a voltage difference between a local data line and a complementary local data line, where at least a partial circuit structure of the first amplification module is the same as at least a partial circuit structure of the second amplification module.

## Description

### CROSS-REFERENCE TO RELATED APPLICATIONS

This application claims priority to Chinese Patent Application No. 202410034319.X, filed with the China National Intellectual Property Administration on January 10, 2024 and entitled "SEMICONDUCTOR MEMORY", which is incorporated herein by reference in its entirety.

### TECHNICAL FIELD

This application relates to but is not limited to a semiconductor memory.

### BACKGROUND

With the popularization of electronic devices such as mobile phones, tablet computers, and personal computers, semiconductor memory technologies are also rapidly developed.

An amplification circuit is disposed in a dynamic random access memory (DRAM), and a voltage difference is amplified by the amplification circuit, to read data from or write data into a memory cell. Therefore, performance of the memory can be improved by improving the amplification circuit.

### SUMMARY

This application provides a semiconductor memory, including a first amplification module, a first control transistor, a second control transistor, and a second amplification module. At least a partial circuit structure of the first amplification module is the same as at least a partial circuit structure of the second amplification module.

The first amplification module is connected to a bit line and a complementary bit line, and is configured to amplify a voltage difference between the bit line and the complementary bit line.

The second amplification module is connected to a local data line and a complementary local data line, and is configured to amplify a voltage difference between the local data line and the complementary local data line.

The local data line is connected to the bit line through the first control transistor, and the complementary local data line is connected to the complementary bit line through the second control transistor. A control terminal of the first control transistor and a control terminal of the second control transistor receive a column selection signal.

The semiconductor memory provided in this application includes the first amplification module, the second amplification module, the first control transistor, and the second control transistor. The first amplification module is configured to amplify the voltage difference between the bit line and the complementary bit line, and the second amplification module is configured to amplify the voltage difference between the local data line and the complementary local data line. The bit line is connected to the complementary local data line through the first control transistor, and the complementary bit line is connected to the complementary local data line through the second control transistor. In this way, data on the bit line and the complementary bit line and data on the local data line and the complementary local data line are transmitted. It is set that at least a partial circuit structure of the first amplification module is the same as at least a partial circuit structure of the second amplification module, so that a layout structure of the first amplification module is similar to a layout structure of the second amplification module. Therefore, a unified preparation process can be utilized for device preparation, thereby reducing process difficulty.

### BRIEF DESCRIPTION OF DRAWINGS

The accompanying drawings herein, which are incorporated into and constitute a part of the specification, illustrate embodiments conforming to this application, and are utilized together with the specification to explain the principles of this application.
FIG. 1 is a schematic circuit diagram of a semiconductor memory;
FIG. 2 is a possible timing control diagram of the semiconductor memory shown in FIG. 1;
FIG. 3 is a schematic circuit diagram of a second amplification module;
FIG. 4 is another schematic circuit diagram of a second amplification module;
FIG. 5 shows a layout of a semiconductor memory;
FIG. 6 shows another layout of a semiconductor memory;
FIG. 7 is a schematic circuit diagram of a semiconductor memory according to some embodiments of this application;
FIG. 8 is a schematic circuit diagram of a semiconductor memory according to some other embodiments of this application;
FIG. 9 is a schematic circuit diagram of a semiconductor memory according to still some other embodiments of this application;
FIG. 10 is a schematic circuit diagram of a semiconductor memory according to yet some other embodiments of this application;
FIG. 11 is a schematic circuit diagram of a second amplification module according to some embodiments of this application;
FIG. 12 is a possible write timing control diagram of a semiconductor memory according to some embodiments of this application;
FIG. 13 is a possible read timing control diagram of a semiconductor memory according to some embodiments of this application;
FIG. 14 shows a layout of a semiconductor memory according to some embodiments of this application;
FIG. 15 shows a layout of a semiconductor memory according to some other embodiments of this application; and
FIG. 16 shows a layout of a semiconductor memory according to still some other embodiments of this application.

Reference numerals:
10: Half-bank; 20: Second control region; 30: First partial region; 301: Second amplification region; 302: Third control region; 303: Fourth control region; 304: Second storage region; 50: First control region; 60: Second partial region; 601: First amplification region; 602: Intermediate region; 603: Fifth control region; 604: First storage region; 605: Drive region; 606: First region; 70: First amplification module; and 80: Second amplification module.

The foregoing accompanying drawings show specific embodiments of this application, which are described in more detail below. These accompanying drawings and text descriptions are not intended to limit the scope of the concept of this application in any manner, but to describe the concept of this application for a person skilled in the art with reference to specific embodiments.

### DESCRIPTION OF EMBODIMENTS

Example embodiments are described herein in detail, and examples thereof are shown in the accompanying drawings. When the following descriptions relate to the accompanying drawings, unless otherwise indicated, the same numbers in different accompanying drawings represent the same or similar elements. Implementations described in the following example embodiments do not represent all implementations consistent with this application. On the contrary, they are merely examples of apparatuses and methods that are consistent with some aspects of this application.

It should be noted that in the embodiments, a high level and a low level are relative concepts (that is, a voltage value of the high level is greater than a voltage value of the low level corresponding to the high level), and neither a specific voltage value of the high level nor a specific voltage value of the low level is limited. In addition, no limitation indicating that high levels applied to different signal lines in specific embodiments are equal is imposed. For example, a high level on a bit line BL and a high level on a word line may be different voltages. Furthermore, no limitation indicating that high levels on a specific signal line in different phases are equal is imposed. A person skilled in the art should understand that corresponding values of the high level and the low level can be independently set based on a process node, a speed requirement, a reliability requirement, and the like.

A semiconductor memory includes a first amplification module 70 and a second amplification module 80. The first amplification module 70 is configured to amplify a voltage difference between a bit line BL and a complementary bit line BLB, and the second amplification module 80 is configured to amplify a voltage difference between a local data line IO and a complementary local data line ION.

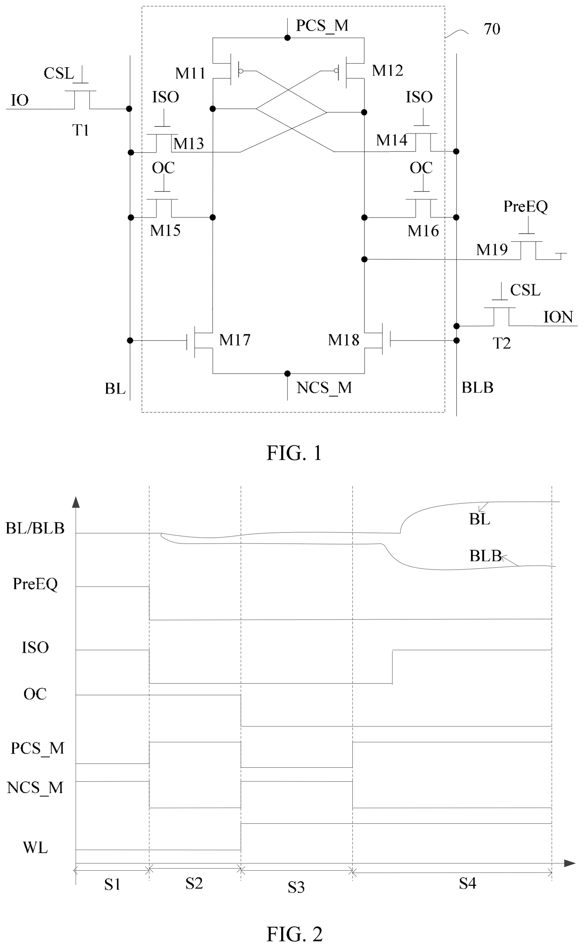

FIG. 1 is a schematic circuit diagram of a semiconductor memory. As shown in FIG. 1, the first amplification module 70 includes an eleventh transistor M11, a twelfth transistor M12, a seventeenth transistor M17, and an eighteenth transistor M18.

A first terminal of the eleventh transistor M11 and a first terminal of the twelfth transistor M12 receive a fourth power signal PCS_M, and a second terminal of the seventeenth transistor M17 and a second terminal of the eighteenth transistor M18 receive a fifth power signal NCS_M.

A second terminal of the eleventh transistor M11 is connected to a first terminal of the seventeenth transistor M17, a control terminal of the eleventh transistor M11 is connected to a second terminal of the twelfth transistor M12, the second terminal of the twelfth transistor M12 is connected to a first terminal of the eighteenth transistor M18, and a control terminal of the twelfth transistor M12 is connected to the second terminal of the eleventh transistor M11.

The first amplification module 70 includes a thirteenth transistor M13 and a fourteenth transistor M14. A control terminal of the seventeenth transistor M17 is connected to the first terminal of the eighteenth transistor M18 through the thirteenth transistor M13, a control terminal of the eighteenth transistor M18 is connected to the first terminal of the seventeenth transistor M17 through the fourteenth transistor M14, and the thirteenth transistor M13 and the fourteenth transistor M14 are turned on or off based on an isolation control signal ISO.

The first amplification module 70 further includes a fifteenth transistor M15 and a sixteenth transistor M16. A first terminal of the fifteenth transistor M15 is connected to the control terminal of the seventeenth transistor M17, and a second terminal of the fifteenth transistor M15 is connected to the first terminal of the seventeenth transistor M17. A first terminal of the sixteenth transistor M16 is connected to the first terminal of the eighteenth transistor M18, and a second terminal of the sixteenth transistor M16 is connected to the control terminal of the eighteenth transistor M18. Both a control terminal of the fifteenth transistor M15 and a control terminal of the sixteenth transistor M16 receive an offset control signal OC, and the offset control signal OC is configured to control the fifteenth transistor M15 and the sixteenth transistor M16 to be turned on or off.

The semiconductor memory further includes a nineteenth transistor M19. A first terminal of the nineteenth transistor M19 is connected to the first terminal of the eighteenth transistor M18, a second terminal of the nineteenth transistor M19 receives a sixth power signal, the sixth power signal provides an equalization voltage, a control terminal of the nineteenth transistor M19 receives a second equalization control signal PreEQ, and the second equalization control signal PreEQ is configured to control the nineteenth transistor M19 to be turned on or off.

The eleventh transistor M11 and the twelfth transistor M12 are P-type transistors, and the thirteenth transistor M13 to the nineteenth transistor M19 are N-type transistors.

FIG. 2 is a possible timing control diagram of the first amplification module 70 shown in FIG. 1. Other timing control may alternatively be applied to the first amplification module 70. This is not limited herein. As shown in FIG. 2, in a precharge phase S1, the second equalization control signal PreEQ is at a high level, the nineteenth transistor M19 is turned on, the isolation control signal ISO is at a high level, the thirteenth transistor M13 and the fourteenth transistor M14 are turned on, the offset control signal OC is at a high level, the fifteenth transistor M15 and the sixteenth transistor M16 are turned on, both the fourth power signal PCS_M and the fifth power signal NCS_M are at an equalization voltage, a word line signal WL is at a low level, a word line is turned off, and the bit line BL and the complementary bit line BLB are precharged to a first precharge voltage.

In an offset cancellation phase S2, the second equalization control signal PreEQ is at a low level, the nineteenth transistor M19 is turned off, the isolation control signal ISO is at a low level, the thirteenth transistor M13 and the fourteenth transistor M14 are turned off, the offset control signal OC is at a high level, the fifteenth transistor M15 and the sixteenth transistor M16 are turned on, the fourth power signal PCS_M is at a supply voltage, the fifth power signal NCS_M is at a ground voltage, the word line signal WL is at a low level, the word line is turned off, and a compensation voltage is formed on the bit line BL and the complementary bit line BLB.

In a charge sharing phase S3, the second equalization control signal PreEQ is at a low level, the nineteenth transistor M19 is turned off, the isolation control signal ISO is at a low level, the thirteenth transistor M13 and the fourteenth transistor M14 are turned off, the offset control signal OC is at a low level, the fifteenth transistor M15 and the sixteenth transistor M16 are turned off, both the fourth power signal PCS_M and the fifth power signal NCS_M are at the equalization voltage, the word line signal WL is at a high level, the word line is turned on, and a shared voltage is formed on the bit line BL and the complementary bit line BLB.

In a sensing amplification phase S4, the second equalization control signal PreEQ is at a low level, the nineteenth transistor M19 is turned off, the isolation control signal ISO is at a high level, the thirteenth transistor M13 and the fourteenth transistor M14 are turned on, the offset control signal OC is at a low level, the fifteenth transistor M15 and the sixteenth transistor M16 are turned off, the fourth power signal PCS_M is at the supply voltage, the fifth power signal NCS_M is at the ground voltage, the word line signal WL is at a high level, the word line is turned on, and the voltage difference between the bit line BL and the complementary bit line BLB is amplified.

It should be noted herein that the isolation control signal ISO, the offset control signal OC, and the second equalization control signal PreEQ are not limited to the foregoing control timing, and there may be another manner. This is not limited herein.

The local data line IO is connected to the bit line BL through a first control transistor T1, and the complementary local data line ION is connected to the complementary bit line BLB through a second control transistor T2. A control terminal of the first control transistor T1 and a control terminal of the second control transistor T2 receive a column selection signal CSL. The column selection signal CSL controls transmission between data on the local data line IO and the complementary local data line ION and data on the bit line BL and the complementary bit line BLB.

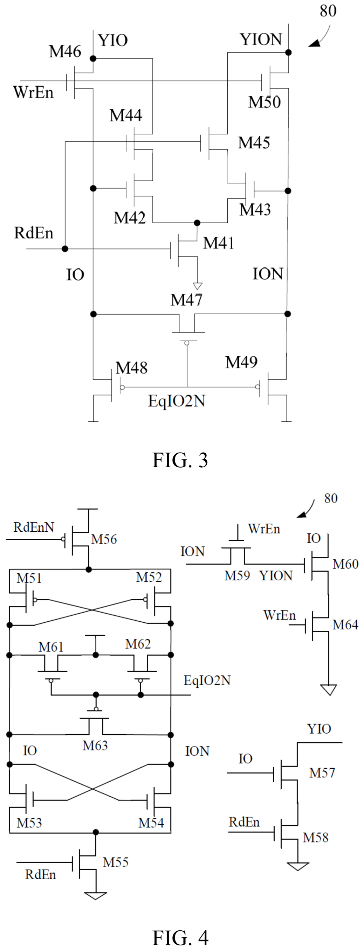

FIG. 3 is a schematic circuit diagram of a second amplification module 80. As shown in FIG. 3, the second amplification module 80 includes a forty-seventh transistor M47, a forty-eighth transistor M48, and a forty-ninth transistor M49. A first terminal of the forty-seventh transistor M47 is connected to the local data line IO, and a second terminal of the forty-seventh transistor M47 is connected to the complementary local data line ION. A first terminal of the forty-eighth transistor M48 is connected to the local data line IO, and a second terminal of the forty-eighth transistor M48 receives a seventh power signal. A first terminal of the forty-ninth transistor M49 is connected to the complementary local data line ION, and a second terminal of the forty-ninth transistor M49 receives the seventh power signal. A control terminal of the forty-seventh transistor M47, a control terminal of the forty-eighth transistor M48, and a control terminal of the forty-ninth transistor M49 receive a second complementary equalization control signal EqIO2N. The second complementary equalization control signal EqIO2N is configured to control the forty-seventh transistor M47, the forty-eighth transistor M48, and the forty-ninth transistor M49 to be turned on or off.

A voltage of the seventh power signal is a second precharge voltage. When the forty-seventh transistor M47, the forty-eighth transistor M48, and the forty-ninth transistor M49 are turned on, voltages on the local data line IO and the complementary local data line ION are charged to the second precharge voltage. The first precharge voltage and the second precharge voltage may be the same or different.

The second amplification module 80 includes a forty-first transistor M41, a forty-second transistor M42, a forty-third transistor M43, a forty-fourth transistor M44, and a forty-fifth transistor M45. A first terminal of the forty-fourth transistor M44 is connected to a global data line YIO, a second terminal of the forty-fourth transistor M44 is connected to a first terminal of the forty-second transistor M42, a second terminal of the forty-second transistor M42 is connected to a first terminal of the forty-first transistor M41, a control terminal of the forty-second transistor M42 is connected to the local data line IO, and a second terminal of the forty-first transistor M41 is grounded.

A first terminal of the forty-fifth transistor M45 is connected to a complementary global data line YION, a second terminal of the forty-fifth transistor M45 is connected to a first terminal of the forty-third transistor M43, a second terminal of the forty-third transistor M43 is connected to the first terminal of the forty-first transistor M41, and a control terminal of the forty-third transistor M43 is connected to the complementary local data line ION.

All of a control terminal of the forty-fourth transistor M44, a control terminal of the forty-fifth transistor M45, and a control terminal of the forty-first transistor M41 receive a read enable signal RdEn. When the read enable signal RdEn enables the forty-fourth transistor M44, the forty-fifth transistor M45, and the forty-first transistor M41 to be turned on, the data on the local data line IO and the complementary local data line ION is amplified and then output to the global data line YIO and the complementary global data line YION.

The second amplification module 80 further includes a forty-sixth transistor M46 and a fiftieth transistor M50. A first terminal of the forty-sixth transistor M46 is connected to the global data line YIO, and a second terminal of the forty-sixth transistor M46 is connected to the local data line IO. A first terminal of the fiftieth transistor M50 is connected to the complementary global data line YION, and a second terminal of the fiftieth transistor M50 is connected to the complementary local data line ION. A control terminal of the forty-sixth transistor M46 and a control terminal of the fiftieth transistor M50 receive a write enable signal WrEn. When the write enable signal WrEn enables the forty-sixth transistor M46 and the fiftieth transistor M50 to be turned on, data on the global data line YIO and the complementary global data line YION is transmitted to the local data line IO and the complementary local data line ION.

FIG. 4 is another schematic circuit diagram of a second amplification module 80. As shown in FIG. 4, the second amplification module 80 includes a fifty-first transistor M51, a fifty-second transistor M52, a fifty-third transistor M53, a fifty-fourth transistor M54, a fifty-fifth transistor M55, and a fifty-sixth transistor M56. Both a first terminal of the fifty-first transistor M51 and a first terminal of the fifty-second transistor M52 are connected to a second terminal of the fifty-sixth transistor M56, a first terminal of the fifty-sixth transistor M56 receives an eighth power signal, a control terminal of the fifty-first transistor M51 is connected to a second terminal of the fifty-second transistor M52, and a control terminal of the fifty-second transistor M52 is connected to a second terminal of the fifty-first transistor M51. The second terminal of the fifty-first transistor M51 is connected to the local data line IO, and the second terminal of the fifty-second transistor M52 is connected to the complementary local data line ION. A first terminal of the fifty-fourth transistor M54 is connected to the complementary local data line ION, a first terminal of the fifty-third transistor M53 is connected to the local data line IO, a control terminal of the fifty-third transistor M53 is connected to the first terminal of the fifty-fourth transistor M54, and a control terminal of the fifty-fourth transistor M54 is connected to the first terminal of the fifty-third transistor M53. Both a second terminal of the fifty-third transistor M53 and a second terminal of the fifty-fourth transistor M54 are connected to a first terminal of the fifty-fifth transistor M55, and a second terminal of the fifty-fifth transistor M55 is grounded.

A control terminal of the fifty-fifth transistor M55 receives a read enable signal RdEn, and the read enable signal RdEn controls the fifty-fifth transistor M55 to be turned on or off. A control terminal of the fifty-sixth transistor M56 receives a complementary read enable signal RdEnN, and the complementary read enable signal RdEnN controls the fifty-sixth transistor M56 to be turned on or off. When the fifty-fifth transistor M55 and the fifty-sixth transistor M56 are turned on, the fifty-first transistor M51, the fifty-second transistor M52, the fifty-third transistor M53, and the fifty-fourth transistor M54 amplify the voltage difference between the local data line IO and the complementary local data line ION.

The semiconductor memory further includes a sixty-first transistor M61, a sixty-second transistor M62, and a sixty-third transistor M63. A first terminal of the sixty-first transistor M61 is connected to the local data line IO, and a second terminal of the sixty-first transistor M61 receives a tenth power signal. A first terminal of the sixty-second transistor M62 receives the tenth power signal, and a second terminal of the sixty-second transistor M62 is connected to the complementary local data line ION. A first terminal of the sixty-third transistor M63 is connected to the local data line IO, and a second terminal of the sixty-third transistor M63 is connected to the complementary local data line ION. A control terminal of the sixty-first transistor M61, a control terminal of the sixty-second transistor M62, and a control terminal of the sixty-third transistor M63 receive a second complementary equalization control signal EqIO2N. Under control of the second complementary equalization control signal EqIO2N, voltages on the local data line IO and the complementary local data line ION are driven to a third precharge voltage. The third precharge voltage is a voltage of the tenth power signal.

The second amplification module 80 further includes a fifty-seventh transistor M57 and a fifty-eighth transistor M58. A first terminal of the fifty-seventh transistor M57 is connected to a global data line YIO, a second terminal of the fifty-seventh transistor M57 is connected to a first terminal of the fifty-eighth transistor M58, a second terminal of the fifty-eighth transistor M58 is grounded, a control terminal of the fifty-eighth transistor M58 receives a read enable signal RdEn, and a control terminal of the fifty-seventh transistor M57 receives the local data line IO. Under control of the read enable signal RdEn, the voltage on the local data line IO is amplified and then output to the global data line YIO.

The second amplification module 80 further includes a fifty-ninth transistor M59, a sixtieth transistor M60, and a sixty-fourth transistor M64. A first terminal of the fifty-ninth transistor M59 is connected to the complementary local data line ION, a second terminal of the fifty-ninth transistor M59 is connected to a complementary global data line YION, a control terminal of the sixtieth transistor M60 is connected to the complementary global data line YION, a first terminal of the sixtieth transistor M60 is connected to the local data line IO, a second terminal of the sixtieth transistor M60 is connected to a first terminal of the sixty-fourth transistor M64, a second terminal of the sixty-fourth transistor M64 is grounded, and a control terminal of the sixty-fourth transistor M64 receives a write enable signal WrEn. A control terminal of the fifty-ninth transistor M59 receives a write enable signal WrEn. Under control of the write enable signal WrEn, a voltage on the complementary global data line YION is amplified and then output to the local data line IO, and the voltage on the complementary global data line YION is transmitted to the complementary local data line ION through the fifty-ninth transistor M59.

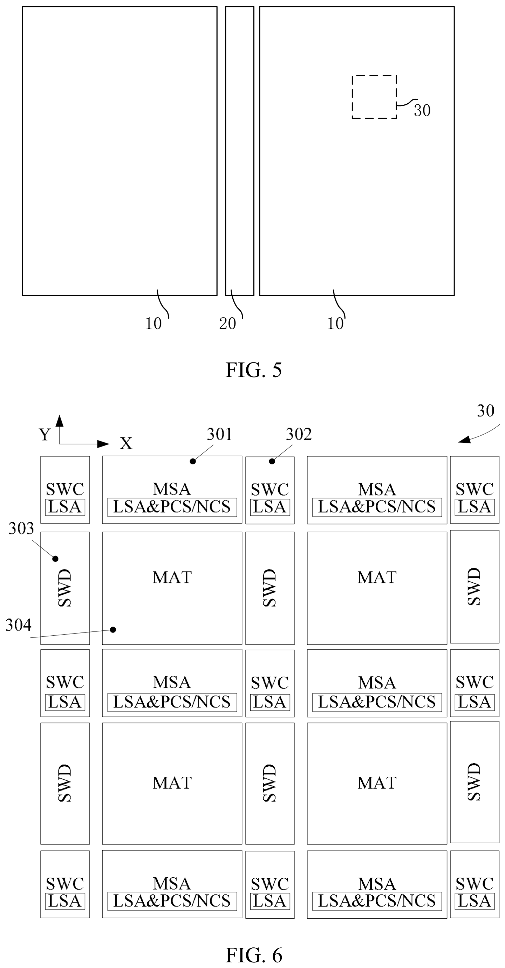

FIG. 5 shows a layout of a semiconductor memory. As shown in FIG. 5, the semiconductor memory includes a bank, and the bank includes two half-banks 10 and a second control region 20. A row decoding circuit is disposed in the second control region 20, and the row decoding circuit is configured to decode a row address of the bank to generate a word line signal. The word line signal is configured to control memory cells in the two half-banks to read/write data.

When the first amplification module 70 and the second amplification module 80 are arranged, a partial structure of the second amplification module 80 is usually arranged in a region in which the first amplification module is located, and the other partial structure of the second amplification module 80 is arranged in another region. FIG. 6 shows an example layout of a semiconductor memory. As shown in FIG. 6, there is a first partial region 30 in each of the half-banks, and the first partial region 30 includes a second storage region (MAT) 304, a second amplification region 301, a third control region 302, and a fourth control region 303. The second amplification region 301 is arranged between two second storage regions 304 arranged in a second direction Y, and a first amplification module (MSA) is arranged in the second amplification region 301.

A partial circuit of a second amplification module (LSA) is further arranged in the second amplification region 301. A third drive circuit (PCS/NCS) is further disposed in the second amplification region 301, and the third drive circuit is configured to provide a power signal to the first amplification module 70 and/or the second amplification module 80.

The third control region 302 is arranged between two second amplification regions 301 arranged in a first direction X, and a partial circuit of the second amplification module (LSA) is disposed in the third control region 302. A first control circuit (SWC) is further arranged in the third control region 302, and the first control circuit (SWC) is configured to control one or a combination of a circuit in the second amplification region 301 or another circuit in the third control region 302.

The fourth control region 303 is arranged between two second storage regions 304 arranged in the first direction X, a second control circuit (SWD) is arranged in the fourth control region 303, and the second control circuit is configured to drive a word line in the second storage region 304.

Because a circuit structure of the first amplification module 70 shown in FIG. 1 is different from a circuit structure of the second amplification module 80 shown in FIG. 3 and FIG. 4, a layout of the first amplification module 70 is different from a layout of the second amplification module 80, and different process procedures are utilized, increasing process difficulty of a device.

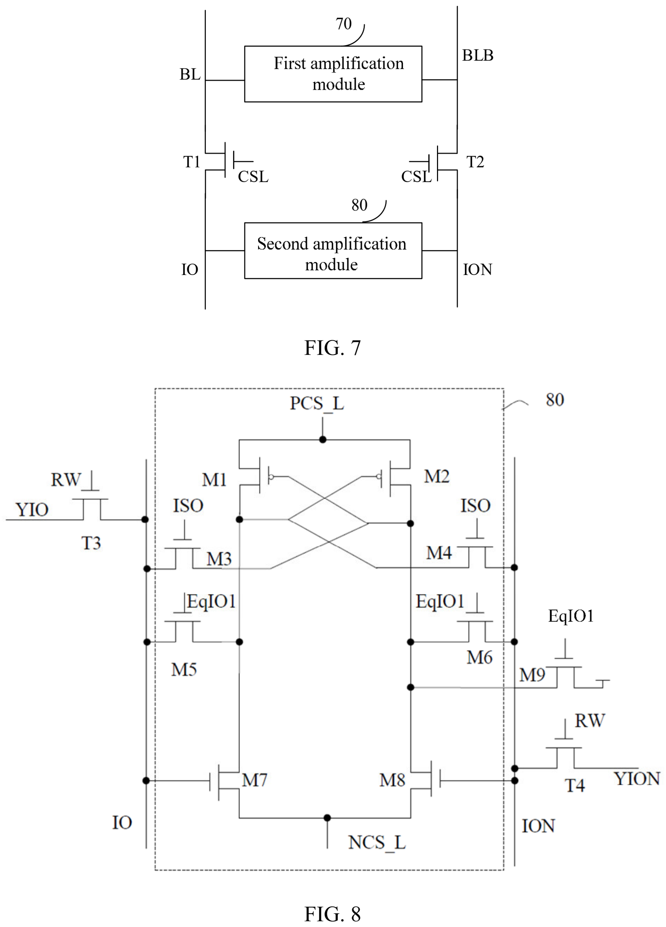

FIG. 7 is a schematic circuit diagram of a semiconductor memory according to some embodiments of this application. As shown in FIG. 7, some embodiments of this application provide a semiconductor memory, including a first amplification module 70, a second amplification module 80, a first control transistor T1, and a second control transistor T2.

At least a partial circuit structure of the first amplification module 70 is the same as at least a partial circuit structure of the second amplification module 80.

The first amplification module 70 is connected to a bit line BL and a complementary bit line BLB, and is configured to amplify a voltage difference between the bit line BL and the complementary bit line BLB. The second amplification module 80 is connected to a local data line IO and a complementary local data line ION, and is configured to amplify a voltage difference between the local data line IO and the complementary local data line ION.

The local data line IO is connected to the bit line BL through the first control transistor T1, and the complementary local data line ION is connected to the complementary bit line BLB through the second control transistor T2. A control terminal of the first control transistor T1 and a control terminal of the second control transistor T2 receive a column selection signal CSL.

That at least a partial circuit structure of the first amplification module 70 is the same as at least a partial circuit structure of the second amplification module 80 specifically means that a first local structure formed by replacing some transistors in the first amplification module 70 with wires or removing some transistors from the first amplification module 70 has the same circuit structure as the second amplification module 80; or a first local structure formed by replacing some transistors in the first amplification module 70 with wires or removing some transistors from the first amplification module 70 has the same circuit structure as a second local structure formed by replacing some transistors in the second amplification module 80 with wires or removing some transistors. It should be noted that when it is determined whether circuit structures are the same, attention is paid only to whether types and positions of transistors included in the circuit structures are the same, and no attention is paid to whether signals received by the transistors are the same.

The column selection signal CSL is configured to control the first control transistor T1 to be turned on or off, and the column selection signal CSL is further configured to control the second control transistor T2 to be turned on or off. When the first control transistor T1 and the second control transistor T2 are turned on, data on the local data line IO and the complementary local data line ION may be transmitted to the bit line BL and the complementary bit line BLB, or data on the bit line BL and the complementary bit line BLB may be transmitted to the local data line IO and the complementary local data line ION.

The data on the bit line BL and the complementary bit line BLB is represented by the voltage difference between the bit line BL and the complementary bit line BLB. When a voltage on the bit line BL is greater than a voltage on the complementary bit line BLB, it indicates that the data on the bit line BL and the complementary bit line BLB is 1; or when a voltage on the bit line BL is less than a voltage on the complementary bit line BLB, it indicates that the data on the bit line BL and the complementary bit line BLB is 0.

Similarly, the data on the local data line IO and the complementary local data line ION is represented by the voltage difference between the local data line IO and the complementary local data line ION. When a voltage on the local data line IO is greater than a voltage on the complementary local data line ION, it indicates that the data on the local data line IO and the complementary local data line ION is 1; or when a voltage on the local data line IO is less than a voltage on the complementary local data line ION, it indicates that the data on the local data line IO and the complementary local data line ION is 0.

In the foregoing technical solution, the semiconductor memory includes the first amplification module 70, the second amplification module 80, the first control transistor T1, and the second control transistor T2. The bit line BL is connected to the local data line IO through the first control transistor T1, and the complementary bit line BLB is connected to the complementary local data line ION through the second control transistor T2. In this way, the data on the bit line BL and the complementary bit line BLB and the data on the local data line IO and the complementary local data line ION are transmitted. The first amplification module 70 is configured to amplify the voltage difference between the bit line BL and the complementary bit line BLB, and the second amplification module 80 is configured to amplify the voltage difference between the local data line IO and the complementary local data line ION, so that the first amplification module 70 and the second amplification module 80 are functionally continuous, and further the first amplification module 70 and the second amplification module 80 can be physically adjacent to each other. It is set that at least a partial circuit structure of the first amplification module 70 is the same as at least a partial circuit structure of the second amplification module 80, so that a layout structure of the first amplification module 70 is similar to a layout structure of the second amplification module 80. Therefore, a unified preparation process can be utilized for device preparation, thereby reducing process difficulty.

In some embodiments, FIG. 8 is a schematic circuit diagram of a semiconductor memory according to some embodiments of this application. As shown in FIG. 8, the semiconductor memory further includes a third control transistor T3 and a fourth control transistor T4. The local data line IO is connected to a global data line YIO through the third control transistor T3, and the complementary local data line ION is connected to a complementary global data line YION through the fourth control transistor T4. Both a control terminal of the third control transistor T3 and a control terminal of the fourth control transistor T4 receive a read/write control signal RW. The read/write control signal RW is generated when the semiconductor memory receives a data read instruction or a data write instruction.

Herein, an example in which the third transistor T3 and the fourth transistor T4 are N-type transistors is utilized for description. When the read/write control signal RW is generated when the semiconductor memory receives the data read instruction, and when the read/write control signal RW is at a high level, the third control transistor T3 and the fourth control transistor T4 are turned on, and the data on the local data line IO and the complementary local data line ION is controlled to be transmitted to the global data line YIO and the complementary global data line YION. When the read/write control signal RW is generated when the semiconductor memory receives the data write instruction, and when the read/write control signal RW is at a high level, the third control transistor T3 and the fourth control transistor T4 are turned on, and data on the global data line YIO and the complementary global data line YION is controlled to be transmitted to the local data line IO and the complementary local data line ION. The third control transistor T3 connecting the local data line IO and the global data line YIO and the fourth control transistor T4 connecting the complementary local data line ION and the complementary global data line YION are disposed, so that the data on the local data line IO and the global data line YIO and the data on the complementary local data line ION and the complementary global data line YION are transmitted. That is, the third control transistor T3 and the fourth control transistor T4 are configured to implement transmission between the data on the local data line IO and the complementary local data line ION and the data on the global data line YIO and the complementary global data line YION, and have functions similar to those of the first control transistor T1 and the second control transistor T2, so that a relative position relationship between the third control transistor T3 and the second amplification module 80 is similar to a relative position relationship between the first control transistor T1 and the first amplification module 70, and a relative position relationship between the fourth control transistor T4 and the second amplification module 80 is similar to a relative position relationship between the second control transistor T2 and the first amplification module 70, to help improve symmetry between a layout at a position of the first amplification module 70 and a layout at a position of the second amplification module 80. Therefore, a unified preparation process can be utilized for device preparation, thereby reducing process difficulty.

In some embodiments, the semiconductor memory further includes multiple third control transistors T3 connected in parallel and multiple fourth control transistors T4 connected in parallel. One terminal of each of the multiple third control transistors T3 is connected to the same local data line IO, and the other terminal of each of the multiple third control transistors T3 is connected to the same global data line YIO. One terminal of each of the multiple fourth control transistors T4 is connected to the same complementary local data line ION, and the other terminal of each of the multiple fourth control transistors T4 is connected to the same complementary global data line YION. The transistors are disposed in parallel, so that a drive capability can be improved, and transmission speeds of the data on the local data line IO and the global data line YIO and the data on the complementary local data line ION and the complementary global data line YION can be increased, to improve read/write performance of the semiconductor memory.

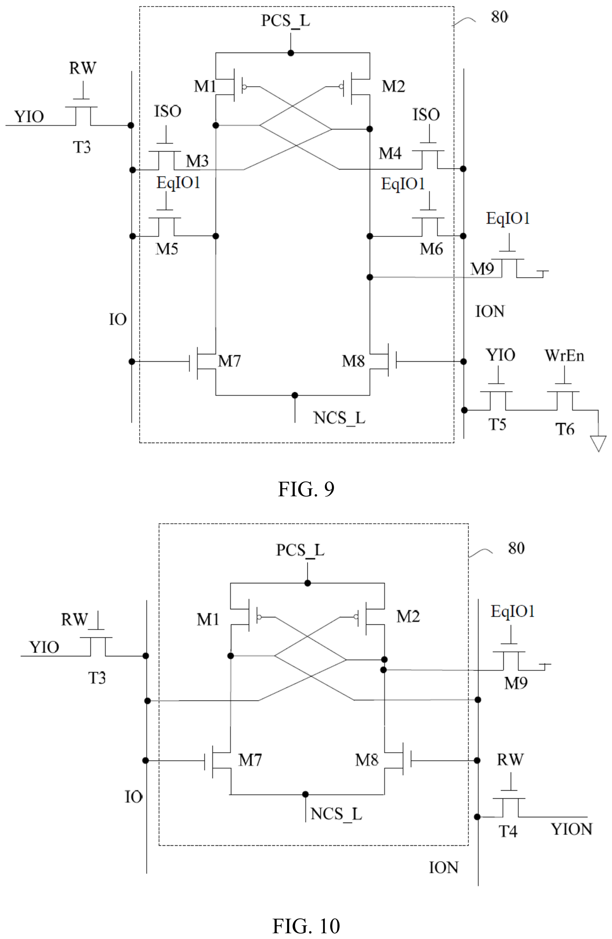

In some embodiments, FIG. 9 is a schematic circuit diagram of a semiconductor memory according to some other embodiments of this application. As shown in FIG. 9, the semiconductor memory further includes a third control transistor T3, a fifth control transistor T5, and a sixth control transistor T6. The local data line IO is connected to a global data line YIO through the third control transistor T3, the complementary local data line ION is grounded through the fifth control transistor T5 and the sixth control transistor T6, and the fifth control transistor T5 and the sixth control transistor T6 are connected in series.

A control terminal of the third control transistor T3 receives a read/write control signal RW, a control terminal of the fifth control transistor T5 is connected to the global data line YIO, and a control terminal of the sixth control transistor T6 receives a write enable signal WrEn. The read/write control signal RW is generated when the semiconductor memory receives a data read instruction or a data write instruction, and the write enable signal WrEn is generated when the semiconductor memory receives the data write instruction.

Herein, an example in which the third transistor T3, the fifth transistor T5, and the sixth transistor T6 are N-type transistors is utilized for description. When the read/write control signal RW and the write enable signal WrEn are generated when the semiconductor memory receives the data write instruction, and when both the read/write control signal RW and the write enable signal WrEn are at a high level, the third control transistor T3 and the sixth control transistor T6 are turned on. If a voltage on the global data line YIO is at a high level, the fifth control transistor T5 is turned on, the complementary local data line ION is grounded, and the local data line IO is driven to a high level, so that data is written on the local data line IO and the complementary local data line ION. If a voltage on the global data line YIO is at a low level, the fifth control transistor T5 is turned off, the complementary local data line ION is maintained at a fourth precharge voltage, and the local data line IO is driven to a low level. It is set that the fourth precharge voltage is greater than the low level and meets a voltage difference requirement, so that data can be written on the local data line IO and the complementary local data line ION.

A sequence of connecting the fifth control transistor T5 and the sixth control transistor T6 in series is not limited herein. In an implementable solution, a first terminal of the fifth control transistor T5 is connected to the complementary local data line ION, a second terminal of the fifth control transistor T5 is connected to a first terminal of the sixth control transistor T6, and a second terminal of the sixth control transistor T6 is grounded. In another implementable solution, a first terminal of the sixth control transistor T6 is connected to the complementary local data line ION, a second terminal of the sixth control transistor T6 is connected to a first terminal of the fifth control transistor T5, and a second terminal of the fifth control transistor T5 is grounded.

That is, the third control transistor T3 and the fifth control transistor T5 respectively implement signal transmission between the local data line IO and the global data line YIO and signal transmission between the complementary local data line ION and the global data line YIO, and have functions similar to those of the first control transistor T1 and the second control transistor T2, so that a relative position relationship between the third control transistor T3 and the second amplification module 80 is similar to a relative position relationship between the first control transistor T1 and the first amplification module 70, and a relative position relationship between the fifth control transistor T5 and the second amplification module 80 is similar to a relative position relationship between the second control transistor T2 and the first amplification module 70, to help improve symmetry between a layout at a position of the first amplification module and a layout at a position of the second amplification module. Therefore, a unified preparation process can be utilized for device preparation, thereby reducing process difficulty.

In some embodiments, the semiconductor memory includes multiple second amplification modules 80. The multiple second amplification modules 80 are connected to the same local data line IO and the same complementary local data line ION. In this way, the multiple second amplification modules 80 can simultaneously amplify a voltage difference between the same pair of local data lines IO and complementary local data lines ION, to increase a voltage difference amplification rate and increase a data read/write rate.

In some embodiments, FIG. 10 is a schematic circuit diagram of a semiconductor memory according to some other embodiments of this application. As shown in FIG. 10, each of the second amplification modules 80 includes a first transistor M1, a second transistor M2, a seventh transistor M7, and an eighth transistor M8.

A first terminal of the first transistor M1 and a first terminal of the second transistor M2 receive a first power signal PCS_L, and a second terminal of the seventh transistor M7 and a second terminal of the eighth transistor M8 receive a second power signal NCS_L.

A second terminal of the first transistor M1 is connected to a first terminal of the seventh transistor M7, a control terminal of the first transistor M1 is connected to a second terminal of the second transistor M2, the second terminal of the second transistor M2 is connected to a first terminal of the eighth transistor M8, a control terminal of the second transistor M2 is connected to the second terminal of the first transistor M1, a control terminal of the seventh transistor M7 is connected to the first terminal of the eighth transistor M8, and a control terminal of the eighth transistor M8 is connected to the first terminal of the seventh transistor M7.

The first amplification module 70 may be of the structure shown in FIG. 1. In this way, a local circuit structure of the first amplification module 70 is the same as a circuit structure of each of the second amplification modules 80. That is, each of the second amplification modules 80 is of a structure obtained after the thirteenth transistor M13 and the fourteenth transistor M14 are replaced with wires and the fifteenth transistor M15 and the sixteenth transistor M16 are removed based on FIG. 1, so that the local circuit structure of the first amplification module 70 is the same as the circuit structure of each of the second amplification modules 80.

In another embodiment, a structure of the first amplification module may alternatively be a structure obtained after only the thirteenth transistor M13 and the fourteenth transistor M14 are replaced with wires based on FIG. 1, or a circuit structure obtained after only the fifteenth transistor M15 and the sixteenth transistor M16 are removed based on FIG. 1. In this way, a partial circuit structure of the first amplification module 70 can be the same as a circuit structure of each of the second amplification modules 80.

In another embodiment, a structure of the first amplification module may alternatively be a circuit structure obtained after the thirteenth transistor M13 and the fourteenth transistor M14 are replaced with wires and the fifteenth transistor M15 and the sixteenth transistor M16 are removed based on FIG. 1. In this way, a circuit structure of the first amplification module 70 can be exactly the same as a circuit structure of each of the second amplification modules 80.

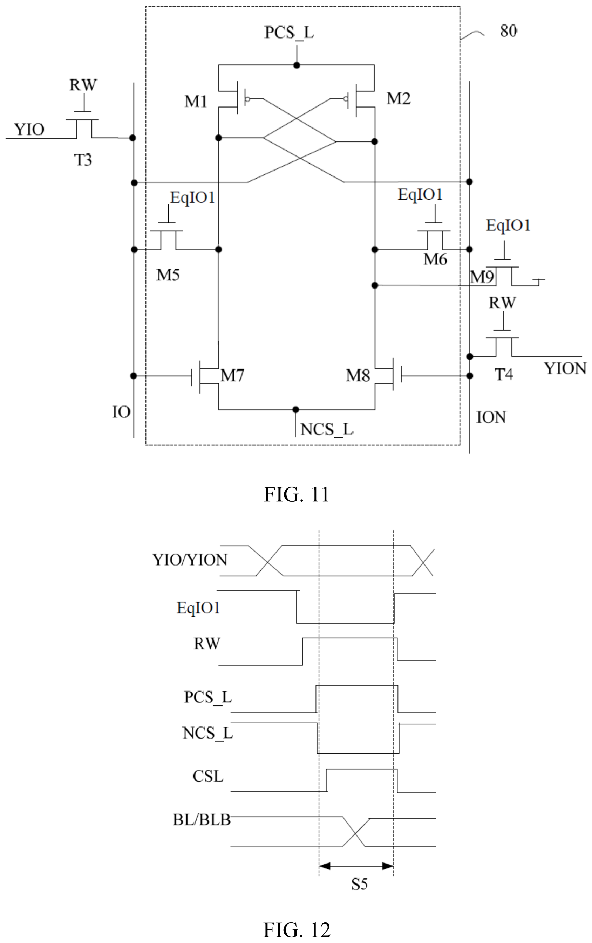

In some embodiments, FIG. 11 is a schematic circuit diagram of a semiconductor memory according to still some other embodiments of this application. As shown in FIG. 11, FIG. 8, and FIG. 9, each of the second amplification modules 80 further includes a fifth transistor M5 and a sixth transistor M6. A first terminal of the fifth transistor M5 is connected to the control terminal of the seventh transistor M7, and a second terminal of the fifth transistor M5 is connected to the first terminal of the seventh transistor M7. A first terminal of the sixth transistor M6 is connected to the first terminal of the eighth transistor M8, and a second terminal of the sixth transistor M6 is connected to the control terminal of the eighth transistor M8.

In some embodiments, a control terminal of the fifth transistor M5 receives a first equalization control signal EqIO1, a control terminal of the sixth transistor M6 receives the first equalization control signal EqIO1, and the first equalization control signal EqIO1 is configured to control the fifth transistor M5 and the sixth transistor M6 to be turned on or off. The first equalization control signal EqIO1 is further configured to control an equalization circuit to precharge the local data line IO and the complementary local data line ION.

The first amplification module 70 may be of the structure shown in FIG. 1. In this way, a partial circuit structure of the first amplification module 70 is the same as a circuit structure of each of the second amplification modules 80. That is, each of the second amplification modules 80 is a result of replacing the thirteenth transistor M13 and the fourteenth transistor M14 with wires based on FIG. 1, so that a local circuit structure of the first amplification module 70 is the same as the circuit structure of each of the second amplification modules 80.

In another embodiment, a structure of the first amplification module 70 may alternatively be a structure obtained after the thirteenth transistor M13 and the fourteenth transistor M14 are replaced with wires and the fifteenth transistor M15 and the sixteenth transistor M16 are removed based on FIG. 1. In this way, a partial circuit structure of the first amplification module 70 is the same as a circuit structure of each of the second amplification modules 80.

In another embodiment, a structure of the first amplification module 70 may alternatively be a structure obtained after the thirteenth transistor M13 and the fourteenth transistor M14 are replaced with wires based on FIG. 1. In this way, a circuit structure of the first amplification module 70 is exactly the same as a circuit structure of each of the second amplification modules 80.

The fifth transistor M5 and the sixth transistor M6 are controlled by utilizing the first equalization control signal EqIO1, to ensure that the fifth transistor M5 and the sixth transistor M6 are in an on state when the equalization circuit performs precharging. This helps precharge the local data line IO and the complementary local data line ION, and can simplify a structure of the equalization circuit.

In some embodiments, as shown in FIG. 8 and FIG. 9, the equalization circuit is connected to the first terminal of the eighth transistor M8, the equalization circuit further receives a third power signal, and the equalization circuit receives the first equalization control signal EqIO1, to control the first terminal of the eighth transistor M8 to receive the third power signal. A voltage of the third power signal falls within [0.5 V, 0.55 V]. In another embodiment, the voltage of the third power signal falls within [1 V, 1.08 V]. When the first equalization control signal EqIO1 enables the first terminal of the eighth transistor M8 to receive the third power signal, the fifth transistor M5 and the sixth transistor M6 are in an on state. This helps precharge the local data line IO and the complementary local data line ION, and simplifies a structure of the equalization circuit.

In some embodiments, the equalization circuit is connected to the first terminal of the seventh transistor M7, the equalization circuit further receives a third power signal, and the equalization circuit receives the first equalization control signal EqIO1, to control the first terminal of the seventh transistor M7 to receive the third power signal. When the first equalization control signal EqIO1 enables the first terminal of the seventh transistor M7 to receive the third power signal, the fifth transistor M5 and the sixth transistor M6 are in an on state. This helps precharge the local data line IO and the complementary local data line ION, and simplifies a structure of the equalization circuit.

In some embodiments, the equalization circuit includes a ninth transistor M9. A first terminal of the ninth transistor M9 is connected to the first terminal of the eighth transistor M8, a second terminal of the ninth transistor M9 receives a third power signal, and a control terminal of the ninth transistor M9 receives the first equalization control signal EqIO1. When the first equalization control signal EqIO1 enables the ninth transistor M9 to be turned on, the first terminal of the eighth transistor M8 receives the third power signal, and the fifth transistor M5 and the sixth transistor M6 are in an on state, to precharge the local data line IO and the complementary local data line ION, and simplify a structure of the equalization circuit.

In some embodiments, as shown in FIG. 7 and FIG. 8, each of the second amplification modules 80 includes a third transistor M3 and a fourth transistor M4. The control terminal of the seventh transistor M7 is connected to the first terminal of the eighth transistor M8 through the third transistor M3, and the control terminal of the eighth transistor M8 is connected to the first terminal of the seventh transistor M7 through the fourth transistor M4.

The third transistor M3 and the fourth transistor M4 are in an always-on state, the third transistor M3 and the fourth transistor M4 are turned on or off based on a read/write control signal RW, or the third transistor M3 and the fourth transistor M4 are turned on or off based on an isolation control signal ISO, and the isolation control signal ISO is further configured to control the first amplification module 70 to amplify the voltage difference between the bit line BL and the complementary bit line BLB.

The first amplification module 70 may be of the structure shown in FIG. 1. In this way, a circuit structure of the first amplification module 70 is the same as a circuit structure of each of the second amplification modules 80.

In another embodiment, a structure of the first amplification module 70 is a structure obtained after the thirteenth transistor M13 and the fourteenth transistor M14 are replaced with wires and the fifteenth transistor M15 and the sixteenth transistor M16 are removed based on FIG. 1. In this way, a partial circuit structure of the first amplification module 70 is the same as a circuit structure of each of the second amplification modules 80.

In another embodiment, a structure of the first amplification module 70 is a structure obtained after the thirteenth transistor M13 and the fourteenth transistor M14 are replaced with wires based on FIG. 1. In this way, a partial circuit structure of the first amplification module 70 is the same as a circuit structure of each of the second amplification modules 80.

In a possible implementation, the third transistor M3 and the fourth transistor M4 are in the always-on state, so that the second amplification module 80 can amplify the voltage difference between the local data line IO and the complementary local data line ION. That is, when the third transistor M3 and the fourth transistor M4 are N-type transistors, a high level is connected to a control terminal of the third transistor M3 and a control terminal of the fourth transistor M4. When the third transistor M3 and the fourth transistor M4 are P-type transistors, a low level is connected to a control terminal of the third transistor M3 and a control terminal of the fourth transistor M4.

In a possible implementation, the third transistor M3 and the fourth transistor M4 are turned on or off based on the read/write control signal RW. Herein, an example in which the third transistor T3 and the fourth transistor T4 are N-type transistors is utilized for description. When the read/write control signal RW is at a high level, the third transistor M3 and the fourth transistor M4 are turned on, so that the second amplification module 80 can amplify the voltage difference between the local data line IO and the complementary local data line ION. When the read/write control signal RW is at a low level, the third transistor M3 and the fourth transistor M4 are turned off, so that the second amplification module 80 cannot amplify the voltage difference between the local data line IO and the complementary local data line ION. All of the third control transistor T3, the fourth control transistor T4, the third transistor M3, and the fourth transistor M4 are controlled by utilizing the read/write control signal RW. This can simplify a control circuit and reduce a layout of a control signal line.

In a possible implementation, the third transistor M3 and the fourth transistor M4 are turned on or off based on the isolation control signal ISO, and the isolation control signal ISO is configured to control the first amplification module 70 to amplify the voltage difference between the bit line BL and the complementary bit line BLB. Herein, an example in which the third transistor T3 and the fourth transistor T4 are N-type transistors is utilized for description. When the isolation control signal ISO is at a high level, the third transistor M3 and the fourth transistor M4 are turned on, so that the second amplification module 80 can amplify the voltage difference between the local data line IO and the complementary local data line ION. When the isolation control signal ISO is at a low level, the third transistor M3 and the fourth transistor M4 are turned off, so that the second amplification module 80 cannot amplify the voltage difference between the local data line IO and the complementary local data line ION. In addition, the first amplification module 70 and the second amplification module 80 share the isolation control signal ISO. This can simplify a control circuit and reduce a layout of a control signal line.

FIG. 12 is a possible write timing control diagram of a semiconductor memory according to some embodiments of this application. The circuit structure in FIG. 7 and the circuit structure in FIG. 11 are taken as examples for description. In a first phase S5, the first equalization control signal EqIO1 is at a low level, and the equalization circuit stops precharging the local data line IO and the complementary local data line ION. The read/write control signal RW is at a high level, the third control transistor T3 and the fourth control transistor T4 are turned on, and the data on the global data line YIO and the complementary global data line YION is transmitted to the local data line IO and the complementary local data line ION. The first power signal PCS_L is at a supply voltage, the second power signal NCS_L is at a ground voltage, the first equalization control signal EqIO1 is at a low level, the fifth transistor M5 and the sixth transistor M6 are turned off, and the second amplification module amplifies the voltage difference between the local data line IO and the complementary local data line ION. The column selection signal CSL is at a high level, the data on the local data line IO and the complementary local data line ION is transmitted to the bit line BL and the complementary bit line BLB, and data is written into a memory cell when a word line is turned on.

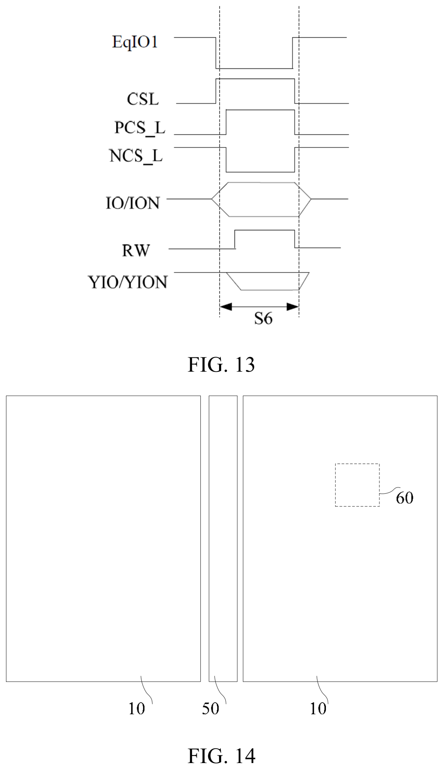

FIG. 13 is a possible read timing control diagram of a semiconductor memory according to some embodiments of this application. The circuit structure in FIG. 7 and the circuit structure in FIG. 9 are taken as examples for description. In a second phase S6, the first equalization control signal EqIO1 is at a low level, and the equalization circuit stops precharging the local data line IO and the complementary local data line ION. The column selection signal CSL is at a high level, and the data on the bit line BL and the complementary bit line BLB is transmitted to the local data line IO and the complementary local data line ION. The first power signal PCS_L is at a supply voltage, the second power signal NCS_L is at a ground voltage, the first equalization control signal EqIO1 is at a low level, the fifth transistor M5 and the sixth transistor M6 are turned off, and the second amplification module amplifies the voltage difference between the local data line IO and the complementary local data line ION. The read/write control signal RW is at a high level, the third control transistor T3 is turned on, and data on the local data line IO is transmitted to the global data line YIO.

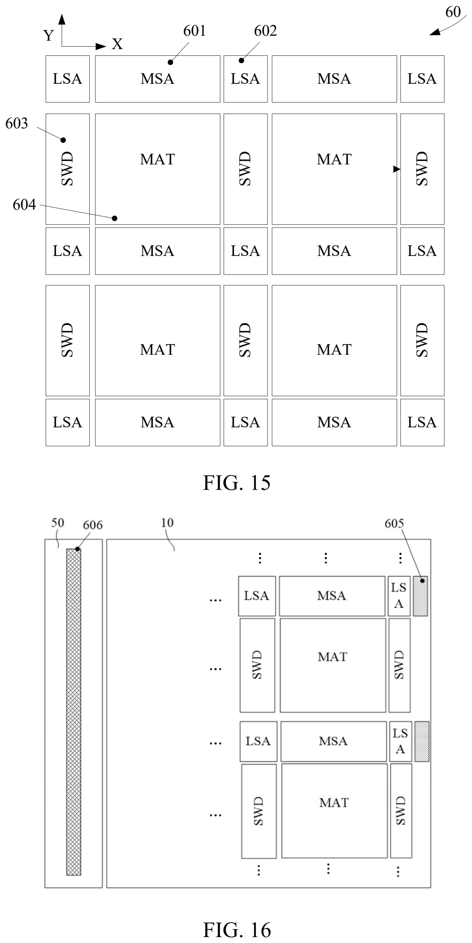

In some embodiments, FIG. 14 shows a layout of a semiconductor memory according to some embodiments of this application. As shown in FIG. 14, the semiconductor memory includes a first control region 50. A half-bank 10 is disposed on either side of the first control region 50, and a row decoding circuit is disposed in the first control region 50, and is configured to decode a row address of a bank. The semiconductor memory further includes a first drive circuit, the first drive circuit is connected to the first amplification module, and the first drive circuit is configured to provide a power signal. For example, the first drive circuit may provide a fifth power signal and a sixth power signal. The first drive circuit is located in the first control region 50. For example, FIG. 16 shows a layout of a semiconductor memory according to some embodiments of this application. FIG. 16 shows only a partial structure of the semiconductor memory. As shown in FIG. 16, a first region 606 is disposed in the first control region 50, and is configured to accommodate the first drive circuit. In such an arrangement, an area of the first amplification region can be decreased. Further, because there are a large quantity of first amplification regions in the bank, the height of the entire bank can be reduced by reducing the height of each first amplification region.

In some embodiments, FIG. 15 shows a layout of a semiconductor memory according to some embodiments of this application. FIG. 15 shows only a partial structure of the semiconductor memory, that is, shows only a second partial region 60 in FIG. 14. As shown in FIG. 15, the semiconductor memory includes multiple first amplification regions 601, the first amplification module is disposed in each of the first amplification regions 601, an intermediate region 602 is arranged between two of the first amplification regions 601 adjacent to each other in a first direction X, and the second amplification module is arranged in the intermediate region 602. Because at least a partial circuit structure of the first amplification module is the same as at least a partial circuit structure of the second amplification module, the first amplification module and the second amplification module may be simultaneously prepared in each of the first amplification regions 601 and the intermediate region 602, thereby reducing process difficulty.

In some embodiments, the semiconductor memory further includes a first storage region 604 and a fifth control region 603. The fifth control region 603 is arranged between two first storage regions 604 arranged in the first direction X, a third control circuit is arranged in the fifth control region 603, and the third control circuit is configured to drive a word line in the first storage region 604.

In some embodiments, FIG. 16 shows a layout of a semiconductor memory according to some embodiments of this application. FIG. 16 shows only a partial structure of the semiconductor memory. As shown in FIG. 16, a drive region 605 is arranged on a side, far away from the first control region 50, of the half-bank. The semiconductor memory includes a first drive circuit and a second drive circuit. The first drive circuit is connected to the first amplification module, and the first drive circuit is located in the first control region 50. The second drive circuit is connected to the first amplification module, and the second drive circuit is arranged in the drive region 605. Both the first drive circuit and the second drive circuit are configured to provide a power signal for the first amplification module. In this way, a drive capability can be improved, and an amplification rate of the first amplification module for the voltage difference between the bit line and the complementary bit line can be increased, thereby improving read/write performance of the semiconductor memory.

In some embodiments, the second drive circuit may provide a power signal to a nearby first amplification module. This helps enhance a power supply situation of the first amplification module at an edge position, and improves read/write performance of the semiconductor memory.

In an implementable solution, the second drive circuit and the first drive circuit may be connected to the same power supply, and provide a power signal to the first amplification module based on the connected power supply. In another implementable solution, the second drive circuit may be connected to the first drive circuit, and the first drive circuit provides a power supply to the second drive circuit, so that the second drive circuit provides a power signal to the first amplification module.

In some embodiments, the first drive circuit and the second drive circuit may further provide a power signal to the second amplification module. For example, both the first drive circuit and the second drive circuit may provide the first power signal and the second power signal.

A person skilled in the art can easily figure out other implementation solutions of this application after consideration of the specification and practice of the present invention disclosed herein. This application is intended to cover any variations, purposes, or adaptive changes of this application. These variations, purposes, or adaptive changes follow the general principles of this application and include common knowledge or conventional technical means in the art that are not disclosed in this application.

It should be understood that this application is not limited to the precise structures described above and shown in the accompanying drawings, and various modifications and changes may be made without departing from the scope thereof. The scope of this application is limited only by the appended claims.

## Claims

1. A semiconductor memory, comprising a first amplification module, a first control transistor, a second control transistor, and a second amplification module, at least a partial circuit structure of the first amplification module being the same as at least a partial circuit structure of the second amplification module;
the first amplification module being connected to a bit line and a complementary bit line, and configured to amplify a voltage difference between the bit line and the complementary bit line;
the second amplification module being connected to a local data line and a complementary local data line, and configured to amplify a voltage difference between the local data line and the complementary local data line; and
the local data line being connected to the bit line through the first control transistor, the complementary local data line being connected to the complementary bit line through the second control transistor, and a control terminal of the first control transistor and a control terminal of the second control transistor receiving a column selection signal.

2. The semiconductor memory according to claim 1, wherein the semiconductor memory comprises a plurality of first amplification regions, and the first amplification module is disposed in each of the first amplification regions; and
an intermediate region is arranged between two of the first amplification regions adjacent to each other in a first direction, and the second amplification module is arranged in the intermediate region.

3. The semiconductor memory according to claim 2, wherein the semiconductor memory further comprises a first drive circuit, the first drive circuit is connected to the first amplification module, and the first drive circuit is configured to provide a power signal; and
the semiconductor memory further comprises a first amplification region, a half-bank is disposed on either side of the first amplification region, a row decoding circuit is disposed in the first amplification region, and is configured to decode a row address of a bank, and the first drive circuit is located in the first amplification region.

4. The semiconductor memory according to claim 3, wherein the semiconductor memory further comprises a second drive circuit, and the second drive circuit is connected to the first amplification module; and
a drive region is arranged on a side, far away from the first amplification region, of the half-bank, and the second drive circuit is arranged in the drive region.

5. The semiconductor memory according to claim 1, wherein the semiconductor memory further comprises a third control transistor and a fourth control transistor;
the local data line is connected to a global data line through the third control transistor, and the complementary local data line is connected to a complementary global data line through the fourth control transistor; and
both a control terminal of the third control transistor and a control terminal of the fourth control transistor receive a read/write control signal, and the read/write control signal is generated when the semiconductor memory receives a data read instruction or a data write instruction.

6. The semiconductor memory according to claim 5, wherein the semiconductor memory comprises a plurality of third control transistors connected in parallel and a plurality of fourth control transistors connected in parallel;
one terminal of each of the plurality of third control transistors is connected to a same local data line, and the other terminal of each of the plurality of third control transistors is connected to a same global data line; and
one terminal of each of the plurality of fourth control transistors is connected to a same complementary local data line, and the other terminal of each of the plurality of fourth control transistors is connected to a same complementary global data line.

7. The semiconductor memory according to claim 1, wherein the semiconductor memory further comprises a third control transistor, a fifth control transistor, and a sixth control transistor;
the local data line is connected to a global data line through the third control transistor;
the complementary local data line is grounded through the fifth control transistor and the sixth control transistor, and the fifth control transistor and the sixth control transistor are connected in series;
a control terminal of the third control transistor receives a read/write control signal, a control terminal of the fifth control transistor is connected to a global data line, and a control terminal of the sixth control transistor receives a write enable signal; and
the read/write control signal is generated when the semiconductor memory receives a data read instruction or a data write instruction, and the write enable signal is generated when the semiconductor memory receives the data write instruction.

8. The semiconductor memory according to claim 1, wherein the semiconductor memory comprises a plurality of second amplification modules, and the plurality of second amplification modules are connected to a same local data line and a same complementary local data line.

9. The semiconductor memory according to claim 8, wherein each of the second amplification modules comprises a first transistor, a second transistor, a seventh transistor, and an eighth transistor;
a first terminal of the first transistor and a first terminal of the second transistor receive a first power signal, and a second terminal of the seventh transistor and a second terminal of the eighth transistor receive a second power signal; and
a second terminal of the first transistor is connected to a first terminal of the seventh transistor, a control terminal of the first transistor is connected to a second terminal of the second transistor, the second terminal of the second transistor is connected to a first terminal of the eighth transistor, a control terminal of the second transistor is connected to the second terminal of the first transistor, a control terminal of the seventh transistor is connected to the first terminal of the eighth transistor, and a control terminal of the eighth transistor is connected to the first terminal of the seventh transistor.

10. The semiconductor memory according to claim 9, wherein each of the second amplification modules further comprises a fifth transistor and a sixth transistor;
a first terminal of the fifth transistor is connected to the control terminal of the seventh transistor, and a second terminal of the fifth transistor is connected to the first terminal of the seventh transistor; and a first terminal of the sixth transistor is connected to the first terminal of the eighth transistor, and a second terminal of the sixth transistor is connected to the control terminal of the eighth transistor;
both a control terminal of the fifth transistor and a control terminal of the sixth transistor receive a first equalization control signal; and
the first equalization control signal is configured to control the fifth transistor and the sixth transistor to be turned on or off.

11. The semiconductor memory according to claim 10, wherein each of the second amplification modules comprises a third transistor and a fourth transistor;
the control terminal of the seventh transistor is connected to the first terminal of the eighth transistor through the third transistor, and the control terminal of the eighth transistor is connected to the first terminal of the seventh transistor through the fourth transistor;
the third transistor and the fourth transistor are in an always-on state, the third transistor and the fourth transistor are turned on or off based on a read/write control signal, or the third transistor and the fourth transistor are turned on or off based on an isolation control signal; and
the isolation control signal is configured to control the first amplification module to amplify the voltage difference between the bit line and the complementary bit line.

12. The semiconductor memory according to claim 9, wherein the semiconductor memory further comprises an equalization circuit;
the equalization circuit is connected to the first terminal of the seventh transistor, or the equalization circuit is connected to the first terminal of the eighth transistor; and
the equalization circuit further receives a third power signal, and the equalization circuit receives a first equalization control signal, to control the first terminal of the seventh transistor or the first terminal of the eighth transistor to be connected to the third power signal.
